Europäisches Patentamt

European Patent Office

Office européen des brevets

(19)

(11) **EP 1 022 847 A2**

(12) **EUROPEAN PATENT APPLICATION**

(43) Date of publication:
26.07.2000 Bulletin 2000/30

(51) Int. Cl.[7]: **H03D 3/20**

(21) Application number: **99660151.4**

(22) Date of filing: **20.09.1999**

| | |
|---|---|
| (84) Designated Contracting States:<br>**AT BE CH CY DE DK ES FI FR GB GR IE IT LI LU MC NL PT SE**<br>Designated Extension States:<br>**AL LT LV MK RO SI** | (72) Inventors:<br>• **Katevuo, Kalle**<br>  **02230 Espoo (FI)**<br>• **Mannonen, Pentti**<br>  **01740 Vantaa (FI)**<br>• **Kängsep, Eiko**<br>  **0036 Tallinn (EE)** |
| (30) Priority: **22.09.1998 FI 982041** | |
| (71) Applicant:<br>**Micro Analog Systems OY**<br>**02770 Espoo (FI)** | (74) Representative:<br>**Äkräs, Tapio Juhani et al**<br>**Oy Kolster Ab,**<br>**Iso Roobertinkatu 23,**<br>**P.O. Box 148**<br>**00121 Helsinki (FI)** |

(54) **FM demodulator**

(57) In a FM demodulator a radio frequency (RF) FM signal is first converted into a modulated intermediate frequency (IF) signal by mixing. Then the difference between the period of the nominal carrier centre frequency and the instantaneous period of the FM signal is determined (54), and an output signal ($Y_d(t)$) which is proportional to said difference, is provided as a demodulated signal.

**Fig. 5**

EP 1 022 847 A2

Printed by Xerox (UK) Business Services
2.16.7 (HRS)/3.6

**Description**

The invention relates to demodulating methods and demodulators for a frequency-modulated (FM) signal.

Frequency-modulation (FM) is widely used in analogue communication systems, including all major analogue cellular systems as well as FM paging. The function of the FM demodulator is to convert the FM modulation, i.e. the frequency deviation, in the received high frequency signal into a lower frequency analogue voltage signal. In a mobile communication technology, the race for a smaller size and an extensive cost reduction in the design of mobile subscriber terminals requires more and more circuit integration in the implementation of the terminals. The number of mounted components should also be minimised in a mass production environment. There are three well known FM demodulators typically used in FM receivers. These are quadrature detector, phase locked loop (PLL) detector, and a zero-crossing detector.

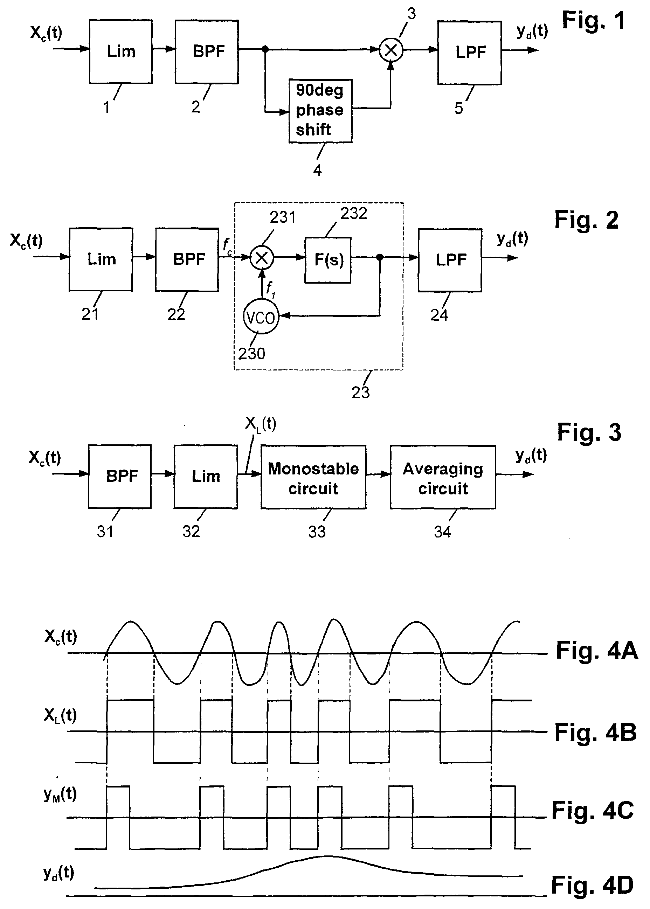

The phase shift discriminator also know as quadrature detector is used in many traditional wireless FM receivers. A simple circuit and a well known operation has been for long the major advantage of the detector. The basic block diagram of the detector is shown in Figure 1. The frequency modulated signal is limited by a limiter circuit 1 and filtered by a bandpass filter (BPF) 2. The bandpass-filtered signal is applied to one input of a multiplier 3 and to a 90-degree phase shifting circuit 4. The output of the phase shifting circuit 4 is applied to another input of multiplier 3. The multiplication result from multiplier 3 is applied to a lowpass filter (LPF) 5 which outputs the demodulated signal. In the integration point of view the limiter circuit 1 and the multiplier 3 (multiplication function) can be integrated into one integrated circuit (IC). The IF bandpass filter is not realisable with an IC process. The 90-degree phase shifting circuit 4 is to be very accurate, which is achieved using two external components: a crystal and a capacitor. Discrete phase shift circuit is relatively large and expensive compared to an fully integrated solution.

Another FM demodulator circuit is shown in the Figure 2. The received FM modulated signal is limited between predetermined signal levels by a limiter 21 and filtered by a band bass filter 22. The feedback tracking circuit 23 is based on a phase locked loop (PLL) principle. A voltage controlled oscillator (VCO) 230 generates a signal with frequency f1 which is applied to a phase detector 231. To another input of the phase detector 231 is applied the output signal of a bandpass filter 22 having a carrier frequency fc. The output of the phase detector is applied to a loop filter (F(s)) 232. The output voltage of the filter 232 is feedbacked to control the frequency of the VCO 231. The PLL automatically adjust the output frequency f1 of the VCO 231 to be equal with the carrier frequency fc, i.e. the PLL locks to the carrier frequency fc. In the locked state, the demodulated low frequency signal appears at the output of the loop filter 232 and may be filtered by a lowpass filter 24. The PLL demodulator principle is suitable to be fully integrated although the implementation of the loop filter 232 maybe difficult. The PLL approach to FM detection is very attractive because the PLL has an ability for extended FM threshold operation. This is the primary reason why the PLL detectors are widely used in the reception of FM broadcasting signals.

However, the PLL approach for a FM demodulator in a wireless communication system has one major disadvantage. In presence of a interference and/or a fading radio channel the operation of the basic PLL demodulator is not satisfactory. The carrier from the desired base station may be occasionally weaker than an interfering carrier from another base station using the same radio channel. In such a case the PLL demodulator will lock to the interfering signal and stay locked in the interfering signal even when the desired signal become stronger again. The PLL has an inherent feature that there is a certain threshold level where the PLL may stay locked in a weaker signal while a stronger signal is present at the same time. However, one requirement in the cellular systems is that it is the strongest signal on a specific radio channel which is normally considered as a desired signal and will be demodulated. The PLL demodulator would require some special circuitry to control the locking threshold level. This would effect to the selection of the loop filter and possibly degenerate other parameters of the PLL demodulator, such as sensitivity.

The most integratable and also well known FM demodulator circuit is a zero-crossing detector. The basic block diagram of the zero-crossing detector is shown in Figure 3. A received FM signal is applied through a bandpass filter 31 and a limiter 32 to a monostable multivibrator circuit 33 which operates at the zero crossings of the received signal. The input signal $X_c$ (t) of the bandpass filter 31 and the output signal $X_L$ (t) of the limiter 32 are shown in Figures 4A and 4B, respectively. The multivibrator 33 is trigged at each negative-to-positive zero-crossing of the signal $X_L$(t), i.e. at each rising edge of the signal $X_L$(t) (or alternatively, at each falling edge of the $X_L$(t)). As a result, the multivibrator 33 produces a pulse of a predetermined constant duration at each zero-crossing of $X_L$(t), as illustrated by a pulse signal $Y_M$(t) in Figure 4C. The rate of these pulses in the signal $Y_M$(t) is inversely proportional to the carrier frequency fc of the signal $X_C$(t), and thereby a demodulated analogue voltage signal $Y_d$(t) can be obtained by averaging the signal $Y_M$(t) by an averaging circuit 34, as shown in Figure

There are, however, several disadvantages in this prior art zero-crossing FM demodulator. The direct current (DC) part of the demodulated signal $Y_d$(t) is large compared to the alternating current (AC) part of the signal. Therefore, the demodulator needs a total DC-blocking in the averaging circuit 34 in order to enable a subsequent amplification of the demodulated signal $Y_d$ (t). The obvious and easy way to block the DC signal is to use a large external decoupling capacitor, but this makes the full integration of the demodulator not feasible

Therefore, there is need for a new demodulation method and demodulator in which the above problems can be alleviated or overcome.

An aspect of the invention is a method of demodulating a frequency-modulated (FM) signal having a nominal carrier centre frequency fc, said method comprising steps of determining a difference between the period 1/fc of the nominal carrier centre frequency and an instantaneous period of said FM signal, providing an output signal which is proportional to said difference, as a demodulated signal.

Another aspect of the present invention a demodulator for a frequency-modulated (FM) signal, comprising means for determining a difference between the period 1/fc of the nominal carrier centre frequency and an instantaneous period of said FM signal, means providing an output signal which is proportional to said difference, as a demodulated signal.

The present invention is based on an idea that the difference between the period of the nominal carrier centre frequency and the instantaneous period of the frequency modulated signal can be used as a good approximation of the instant deviation of the received FM signal, especially when the modulation (deviation) is narrow. Therefore, according to the present invention, the difference between the period of the nominal carrier centre frequency and the instantaneous period of the FM signal is determined, and an output signal which is proportional to said difference, is provided as a demodulated signal.

The new demodulating method according to the invention can be embodied by various circuits which measure the nominal and instantaneous periods of the signal and/or the difference between them. In a zero-crossing FM demodulator according to the invention an output voltage proportional to the difference of the instantaneous period of the received signal from the nominal centre frequency period of a carrier is produced. As a consequence, there will be no large DC levels in the demodulator as compared with the prior art zero-crossing demodulator circuit. Thus, the FM demodulator according to the invention can be fully fabricated with, integrated semiconductor process.

In the preferred embodiment of the invention the radio frequency (RF) FM signal is first converted into a modulated intermediate frequency (IF) signal by mixing. The modulation information is preserved in the frequency/period variation of the IF signal in this mixing process. The advantage of the down-conversion is that the implementation of the signal demodulation according to the invention is more feasible at lower frequency. As a matter of fact, the demodulator of the invention is suitable to be integrated in a baseband signal processing circuit of a receiver when implemented in the IF frequency range. In the IF implementation one external component in form of a DC decoupling capacitor may be required. This DC decoupling capacitor separates the DC levels between an external IF amplifier and the integrated demodulator circuit.

In the following, the invention will be described by means of preferred embodiments with reference to the accompanying drawings, in which

Figure 1 is a block diagram of a prior art quadrature FM demodulator,
Figure 2 is a block diagram of a prior art phase locked FM demodulator,
Figure 3 is a block diagram of a prior art zero-crossing detecting FM demodulator,
Figures 4A, 4B, 4C and 4D are signal diagram illustrating the principle of operation of the FM demodulator in Figure 3,
Figure 5 is a block diagram illustrating the FM demodulator according to the present invention,
Figures 6A, 6B, 6C and 6D are signal diagrams showing the signal waveforms of the FM demodulator when operating according to a first embodiment of the invention,
Figure 7 is a block and schematic diagram illustrating the sampling circuit 54 in Figure 5 according to a second embodiment of the present invention,
Figures 8A, 8B, 8C and 8D are signal diagrams illustrating the signal waveforms in the sampling circuit of Figure 7,
Figure 9 is a block diagram of a pipelined full rate sampling circuit according to a third embodiment of the invention.

According to the preferred embodiments of the invention, the radio frequency (RF) frequency-modulated (FM) signal (received over a radio path, for example) is first converted to an intermediate frequency (IF) signal by mixing. The implementation of the signal demodulation according to the present invention is more reasonable at lower frequency. The FM modulation information is preserved in the variation of frequency/period of the IF signal in this down-converting mixing process. However, it should be appreciated that the FM demodulation principle is applicable also to an RF signal, or more generally, to a signal of any frequency.

The FM demodulation of the IF signal is possible with a circuitry that measures the period of an incoming IF signal. According to the principles of the present invention the difference between the instantaneous period ($T_i$) for the incoming IF signal and the period of the nominal centre frequency $f_c$ of the carrier can be used as a good approximation of the instantaneous deviation of the received carrier signal, especially when the modulation is narrow, such as 1% of the carrier. The difference can be denoted as $\Delta t = T_i - 1/f_c$).

In the following, a description of the theoretical basis of the invention will be made. As well known in the art, for frequency modulated signals the frequency of the carrier is proportional to the amplitude of the modulating signal. Let us consider a tone modulated FM signal, for example. The instantaneous frequency $f_i(t)$ of the carrier $f_c$ modulated by a modulating signal $f_d\, m(t)$ is

$$f_i(t) = f_c + f_d m(t)$$

In a more general case for any arbitrary modulating signal $\Delta f(t)$ we can write

$$f_i(t) = f_c + \Delta_f(t)$$

for the instantaneous carrier frequency $f_i(t)$ and

$$T_i(t) = \frac{1}{f_c + \Delta f(t)}$$

for the instantaneous period. $T_i(t)$. The symbol $\Delta f$ represents the portion of the modulated signal containing the modulation information. The mean value of the instantaneous period of the carrier can be expected to be

$$\overline{T_i(t)} = \frac{1}{f_c}$$

The discrimination function requires that the output from a FM demodulator depends linearly on the term $\Delta f$. Subtracting the mean from the instantaneous period we will have

$$T_i - \overline{T_i} \approx \frac{1}{f_c + \Delta f} - \frac{1}{f_c}$$

$$= \frac{-\Delta f}{f_c^2 + f_c \cdot \Delta f}$$

if $f_{c_c} \gg \Delta f$, the FM demodulation (frequency discrimination) can be approximated with

$$T_i - \overline{T_i} = \Delta T_i \approx \frac{-\Delta f}{f_c^2}$$

This approximation is valid when the second term at the denominator is much smaller than the first one and states that the FM discrimination is possible with a circuit that produces output voltage proportional to the difference between the instantaneous period of the carrier and the nominal centre frequency period of the carrier. Such circuit will produce an output voltage

$$V_o = \Delta T \cdot K_T \approx \frac{-\Delta f}{f_c^2} \cdot K_T$$

The $K_T$ is a detection constant in terms of voltage per second. Linear approximation is not perfect and so the demodulated signal will be distorted. The distortion is caused mainly by an increase in the first harmonic term.

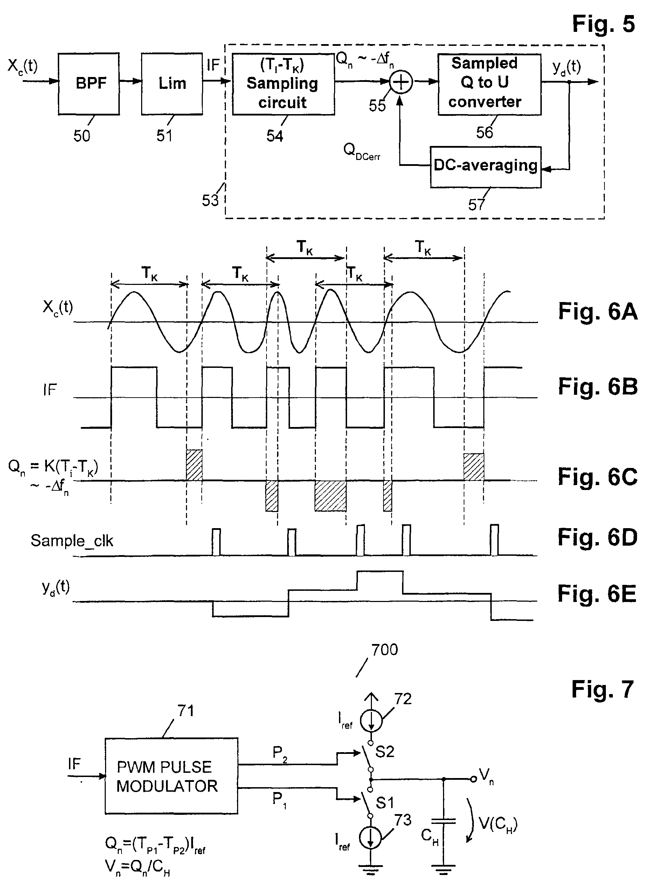

A simplified block diagram of a demodulator according to the present invention is shown in Figure 5. Firstly, a FM modulated RF signal is down-converted into a intermediate frequency FM signal $X_c(t)$ by a mixer. The waveform of signal $X_c(t)$ is illustrated in Figure 6A. The signal $X_c(t)$ is applied through a bandpass filter 50 to a limiter 51. The output IF of the limiter 51 changes its state at each negative and positive zero-crossing of a signal $X_c(t)$ and produces a pulse signal in which the instantaneous period is equal to the instantaneous period of the signal $X_C(t)$, as shown in Figure 6B. This filtering and limiting operation limits the received noise band and suppresses the amplitude modulation. The bandpass filter 50 and the limiter 51 are not, however, necessary to the basic FM demodulation method of the invention, although they are shown in the preferred embodiment. In general, the signal IF in Figure 5 may be any signal containing frequency modulation.

In Figure 5, the core of the FM demodulator is a zero-crossing detector 53. The new zero-crossing detector 53 consists of a charge sampling circuit 54, a sample-to-voltage converter 56, and a DC-cancelling feedback loop formed by the DC averaging circuit 57 and a summing circuit55.

In the first embodiment of the invention the charge sampling circuit 54 generates one charge sample (a pulse) for each period of the signal $X_C(t)$. The charge sample pulse is generated by subtracting a constant time period (TK) from the instantaneous period ($T_i$) of the incoming signal $X_t(t)$, and thereby the length of the each charge sample pulse $Q_n$ will be proportional to a time difference $\Delta t = T_i - T_K$, i.e. $Q_N = K(T_i - T_K)$, wherein K is a detection constant in terms of Coulomb per second. By selecting the time $T_K$ to be equal to the mean value of the carried period (1/fc), a zero pulse is generated when $T_i = T_K$, a positive pulse is generated when $T_i > T_K$, and a negative pulse is generated when $T_i < T_K$. As noted above, the length of the pulses are proportional to the time difference $\Delta t$. Due to the negative and positive charge samples (pulses) the DC component of the signal will be small. The resulting signal $Q_n$ at the output of the sampling circuit 54 is illustrated in Figure 6C.

The output signal $Q_n$ from the sampling circuit 54 is then converted to an analogue output voltage $Y_d(t)$ by the converter 56, such as a switched capacitor (SC) amplifier with a lowpass frequency characteristic.

In the preferred embodiment of the invention a feedback DC charge sample $Q_{DCerr}$ is summed to each charge sample (pulse) $Q_n$ by the adder 55. The integration is provided by the DC averaging circuit 57 so that the integration time constant corresponds to a very low frequency which is substantially below the desired frequency band of the baseband output signal $Y_d(t)$. Any DC offset caused by a centre frequency offset of the carrier, the circuit non-idealities and the received low-frequency noise will be removed by the feedback operation.

A sampling circuit 54 according to a second embodiment of the present invention is shown in Figure 7. The sampling circuit 54 comprises a pulse width modulator PWM (71) which converts the incoming FM modulated IF signal into two pulse signals P1 and P2, and a current switch circuit controlled by the signals P1 and P2. The main advantage of this embodiment is to allow generation of charge samples $Q_n$ with both polarities, as illustrated by signal $Q_n$ in Figure 6C.

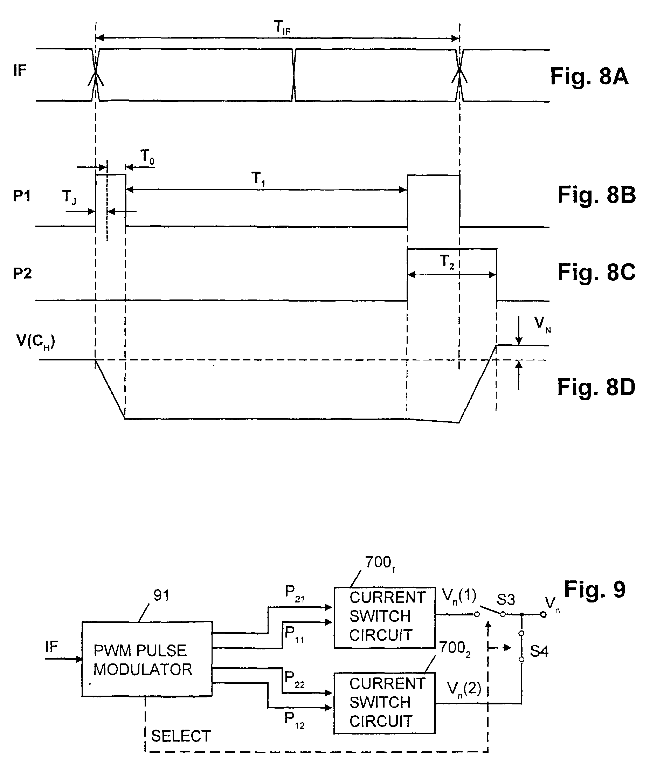

Firstly, operation of modulator 71 will be described with reference to Figures 8A, 8B and 8C. The modulator 71 changes the state of the first pulse signal P1 from a logical "low" state to a logical "high" state at the rising (or falling) edge in the beginning of the instantaneous period of the signal IF. The logic state of P1 is maintained high until a predetermined delay $T_0$ has elapsed, i.e. a pulse of duration $T_0$ is generated. Then the signal P1 is maintained in the logical low state until a second predetermined delay $T_1$ has elapsed. At this point the logical states of both the state P1 and the signal P2 (which have been in a logical low state from the beginning of the instantaneous period of the signal IF until now) are changed to high state. The signal P1 keeps the high state until the end of the signal IF, while the signal P2 is maintained in the high state until a third predetermined delay $T_2$ has elapsed, i.e. the pulse of duration $T_2$ is generated in the signal P2. The delay time $T_1$ and $T_2$ are selected so that both signals P1 and P2 are at high state for an identical time during one IF signal period when the instantaneous frequency of the signal IF is equal to the nominal centre frequency $f_c$. This criteria is fulfilled by selecting delay times to meet an equation $T_2 = 1/f_c - T_1$. The frequency modulation is represented by the difference between the time $T_{P1}$ the signal P1 is in a high state and the time $T_{P2}$ the signal P2 is in a high state, i.e. $\Delta t = T_{P2} - T_{P1}$. The value of the delay time $T_2$ defines the dynamic range of the measurement of the time difference $\Delta t$. If the instantaneous frequency of the signal IF is higher than the nominal centre frequency $f_c$, as in the example shown in Figures 8A-8D, the instantaneous period of IF signal is small compared to the period $T_c$ of the nominal centre frequency $f_c$ (the period of unmodulated signal) and the signal P2 is in a high state longer time than the signal P1 during one period of IF signal, i.e. the signal P2 has longer pulse width than the signal P1. Similarly, if a instantaneous frequency of the signal IF is lower than the centre frequency $f_c$, the pulse width of the signal P2 is shorter than the pulse width all the signal P1. If the instantaneous frequency of the signal IF is equal to the $f_c$, the pulse with of the signal P2 is equal to that of the signal P1. It should be appreciated that the polarity of signals IF, P1 and P2 can be changed from that shown in Figures 8A-8C, if required.

The special pulse width modulation (PWM) contained in the signals P1 and P2 is then converted to an analogue output voltage $V_n$ by the current switch circuit 700. More particularly, signals P1 and P2 are used as control signals for opposite polarity currency switches S1 and S2 which are arranged to charge a hold capacitor $C_H$ during one period of the signal IF. When the signal $P_1$ is high, the switch S1 is closed and the capacitor $C_H$ is discharged by a reference current $I_{ref}$. This results in a decrease in the voltage $V (C_H)$ across the capacitor $C_H$, as illustrated by the voltage drop during the first pulse of P1 in Figure 8D. When both signals P1 and P2 are in a low state, the capacitor $C_H$ is neither charged or discharged, and the voltage $V (C_H)$ is unchanged, as illustrated during the delay $T_1$ in Figure 8D. When the signal $P_2$ is in the high state, the switch S2 is closed and the reference current $I_{ref}$ generated by a current source 72 charges the capacitor $C_H$. When both the signals $P_1$ and $P_2$ are in the high state, their charging and discharging operation will cancel each other and the output voltage $V (C_H)$ is maintained substantially unchanged. Signals P1 and P2 are most of the time simultaneously in the high state. This is especially true when $T_0$ is selected so that the condition $T_0 \ll T_2$ is met. The voltage swing in the output is minimised and so the dynamic operation range requirement of the current switches S1 and S2 is minimised. As a result of the charging and decharging operation described above, the output voltage is $V_n = Q_n/C_H$, where in $Q_n = (T_{P2} - T_{p1}) I_{ref}$.

The voltage $V(C_H)$ may drift during the time when both of the signals P1 and P2 are in the high state, if the reference currents of the current sources 72 and 73 do not match perfectly. This introduces DC-offset into the sample. Also, it is not possible to select the delays $T_1$ and $T_2$ so that the equation $T_2 = T_c - T_1$ is fulfilled perfectly. This is due to the fact the centre frequency of the carrier may vary and there will be some non-symmetry introduced by the internal delays in the circuit 71 generating the P1 and P2 pulses. This may cause a further DC offset in the output voltage. However, this DC offset will be removed by the negative integrating feedback described above.

In an embodiment of the present invention the reference currents $I_{ref}$ are generated for the currency switches S1 and S2 so that the reference current $I_{ref}$ is proportional to a reference capacitor value $C_R$. Because the voltage sample at the hold capacitor $C_H$ is inversely proportional to the capacitance thereof and proportional to the reference current $I_{ref}$, the voltage V

($C_H$) across the hold capacitor $C_H$ will be dependent of a relative component matching between the capacitors $C_H$ and $C_R$ rather than of the absolute component values thereof. The proportional current for the capacitor $C_R$ is generated by a feed back controlled oscillator circuit. The oscillator circuit charges the reference capacitor $C_R$ up to the reference voltage $V_{ref}$ in the integrated circuit chip. A feedback will force the charging current to have such a value that the voltage across the capacitor $C_R$ will reach the $V_{ref}$ during a reference time $T_{ref}$. The tolerances of $V_{ref}$ and $T_{ref}$ can be minimised. By this arrangement, the demodulated output voltage is well controlled and the converter gain (detection constant K) of the demodulator can be selected with a certain amount of freedom. If the detection constant is allowed to vary, the current reference may be generated by other means.

As described above, the implementation of the period measurement according to the invention results in a sampled data system. Each period of the signal IF is first "measured" by the charging/discharging of the hold capacitor $C_H$, and the voltage sample is then sampled out by the subsequent converter 56 (Figure 5), as described above. The sampling causes phase noise aliasing effects which are especially several in a FM system if the sampling frequency is lower than the measured IF frequency. According to the third embodiment of the present invention, a two-phase pipelined sampling is employed in order to avoid the above problem. The pipeline operation of the sampling circuit enables a full rate sampling of the IF signal and thereby prevents the extra aliasing of the phase noise. An example of a full rate pipelined charge sampling circuit is shown in Figure 9. The sampling circuit comprises two current switch circuits $700_1$ and $700_2$ which are similar to the current switch circuit 700 shown in Figure 7. Current switch circuit $700_1$ is controlled by signals $P_{11}$ and $P_{21}$ from the modulator 91. Similarly, current switch circuit $700_2$ is controlled by signals $P_{12}$ and $P_{22}$ from the modulator 91. The signals $P_{11}$ and $P_{21}$ are similar to the signal $P_1$, and signals $P_{21}$ and $P_{22}$ are similar to the signal $P_2$ described with respect to Figures 7 and 8. The signals P1 and P2 are doubled so that in a first phase of the operation (called an even phase herein) a deviation in the instantaneous period of the signal IF is sampled by the current switch circuit $700_1$, while the sample from the previous period of a signal IF is held in the current switch circuit $700_2$ and sampled to the output voltage $V_n$. In the even phase of operation the output of the current switch $700_2$ is connected to the output of the sampling circuit through a closed switch S4, while the output of the current switch circuit $700_1$ is disconnected from the output of the sampling circuit by an open switch S3, as shown in Figure 9. The switches S3 and S4 are controlled by a signal SELECT from the PWM modulator 91. In the second phase of operation (called an odd phase herein) the instantaneous period of the IF is sampled by the current switch circuit $700_2$, while the current

switch circuit $700_1$ is holding the previous sample which is transferred to the output voltage $V_n$ (switch S3 closed, switch S4 opened).

Generation of signals P1 and P2 has a limited dynamic range. This is because of the fact that minimum pulse length of the second pulse in the signal P1 is zero and the maximum length of the pulse must be limited to the end of the pulse in the signal P2. Thus, the length $T_2$ of the P2 pulse controls the dynamic range of the detection and sets the maximum deviation which can be detected. According to the fourth embodiment of the invention a overflow detection is introduced into the generation of the signals P1 and P2 in order to discard rejected samples from the current switch circuit 700 if the deviation in the received signal exceeds the dynamic range of the signal P1. In the preferred embodiment of the invention this overflow detection is combined to the two-phase sampling principle described above with respect to Figure 9. The modulator 91 monitors the start of second raising edge (i.e. beginning of a new IF period). When the second raising edge of the signal IF is detected before the start of the delay $T_2$ or after the delay $T_2$ is elapsed (Figures 8A-8D), the modulator 91 determines that the deviation exceeds the dynamic range of the signal P1. Upon detecting the overflow the modulator 91 controls the respective current switch circuit $700_1$ or $700_2$ to discard a hold capacitor $C_H$ to ground, with a switch connected from $C_H$ to signal ground. Since the output of the current switch circuit is not valid in this case, it is not sampled to the converter 56 but a last valid sample from one of the previous periods is maintained at the input of the converter. This arrangement ensures the safe operation of the sampling circuit. Further advantage is that a reception in a noisy or interfered signal reception is more sensitive when the "spike" noise is disregarded (rejected) by means of this overflow detection.

Although certain preferred embodiments have shown and described, it should be understood that many changes and modifications may be made therein without departing from the scope and of the appended claims.

## Claims

1. Method of demodulating a frequency-modulated (FM) signal having a nominal carrier center frequency fc, characterized by said method comprising steps of

   determining a difference between the period 1/fc of the nominal carrier center frequency and an instantaneous period of said FM signal, providing an output signal which is proportional to said difference, as a demodulated signal.

2. The method according to claim 1, wherein said step of determining comprises further steps of

limiting said FM signal into a rectangular wave signal,

providing a pulse of a first polarity each time when the instantaneous period is longer than said period of said nominal carrier frequency, the duration of said pulse being proportional to said difference,

providing a pulse of a second polarity each time when the instantaneous period is shorter than said period of said nominal carrier frequency, the duration of said pulse being proportional to said difference,

converting the resulting pulse train into said demodulated signal.

3. The method according to claim 2, wherein said step of converting comprises steps of

using said pulse signal for controlling charging and discharging of a hold capacitor by a reference current so as to produce a charge sample representing said difference,

converting the charge sample in the hold capacitor into an analog voltage signal serving as said demodulated signal.

4. The method according to claim 1, wherein said steps of determining and providing comprise steps of

limiting said FM signal into a rectangular wave signal,

providing a first pulse signal by

i) setting the first pulse signal into a first state for a first delay period T0 at the beginning of said instantaneous period,

ii) resetting the first pulse signal into a second state for a second delay period T1 after said delay period T0 has elapsed,

iii) setting the first pulse signal into said first state after said second delay period T1 has elapsed,

iv) resetting the first pulse signal into said second state at the end of said instantaneous period,

providing a second pulse signal by

i) setting the second pulse signal into first state for a third delay period T2 after a delay period T1+T0 has elapsed from the beginning of said instantaneous period, wherein T2 is approximately equal to 1/fc-T1,

ii) resetting the second pulse signal into the second state after said third delay period T2 has elapsed,

using said first and second pulse signal for controlling opposite polarity current switches charging a hold capacitor by a reference current during one period of said FM signal so as to produce a charge sample representing said difference,

converting the charge sample in the hold capacitor into an analog voltage signal serving as said demodulated signal.

5. The method according to claim 4, comprising further steps of

detecting the end of said instantaneous period prior to the start of the third delay period T2 or after the third delay period has elapsed,

discarding the charge sample obtained in the respective instantaneous period in response to said detection,

utilizing last valid charge sample obtained in previous valid instantaneous periods.

6. The method according to claim 3, 4 or 5, comprising a step of

using two or more hold capacitors in a pipelined manner so that, during each period of said FM signal, one of the hold capacitors is sampling a new charge sample while the other one of said hold capacitors is holding a charge sample of the previous period.

7. The method according to claim 3, 4, 5 or 6, wherein comprising a further steps of

providing a feedback charge sample from said analog voltage signal by an integrating negative feedback circuit having an integration time constant which corresponds to a frequency which is substantially lower than the desired demodulated frequency band of said analog voltage signal,

summing said feedback charge sample to charge in the hold capacitor.

8. The method according to any one of the preceding claims, wherein said FM signal is an intermediate frequency FM signal converted down from a radio frequency FM signal.

9. A demodulator for a frequency-modulated (FM) signal, characterized by comprising

means (54) for determining a difference between the period 1/fc of the nominal carrier center frequency and an instantaneous period of said FM signal (IF),

means (55,56,57) for providing an output signal

## EP 1 022 847 A2

($Y_d(t)$) is proportional to said difference, as a demodulated signal.

10. The demodulator according to claim 9, comprising

a limiter (51) limiting said FM signal into a rectangular wave signal,
a pulse generator (54) having an input for receiving said reactangular wave signal and at least one output, for generating a pulse of a first polarity or of a second polarity at said at least one output each time when the instantaneous period is longer or shorter, respectively, than said period of said nominal carrier frequency, the duration of said pulse being proportional to said difference, and
a converter (56) converting the resulting pulse train into said demodulated signal.

11. The demodulator according to claim 10, wherein said converter comprises

a hold capacitor ($C_H$), said pulse signal being arranged to control charging and discharging of said hold capacitor by a reference current so as to produce a charge sample representing said difference,
an amplifier converting the charge sample in the hold capacitor into an analog voltage signal serving as said demodulated signal.

12. The demodulator according to claim 9, comprising

a limiter (51) limiting said FM signal into a rectangular wave signal,
a pulse generator (71) having a first pulse signal output (P1) and a second pulse signal output (P2),
said first pulse signal output (P1) having i) a first state for a first delay period T0 from the beginning of said instantaneous period, ii) a second state for a second delay period T1 after end of said first delay period T0, iii) said first state from the end of said second delay period T1 to the end of said instantaneous period,
said second pulse signal output (P2) having said first state for a third delay period T2 after end of said delay period T1 and having said first state otherwise, wherein T2 is approximately equal to 1/fc-T1,
at least one hold capacitor ($C_H$),
opposite polarity current switches (S1,S2) charging and discharging said hold capacitor ($C_H$) by a reference current,
said first and second pulse signals (P1,P2) being arranged to control said current switches (S1,S2) so as to produce a charge sample representing said difference during one period of said FM signal,
converter (56) for converting the charge sample in the hold capacitor into an analog voltage signal sewing as said demodulated signal.

13. The demodulator according to claim 12, further comprising

detector for detecting the end of said instantaneous period,
means responsive to said detector for discarding the charge sample obtained in the respective instantaneous period in response to said detection and utilizing last valid charge sample obtained in previous instantaneous periods, when the end of said instantaneous period is prior to the start of the third delay period T2 or after the third delay period has elapsed.

14. The demodulator according to claim 11, 12 or 13, comprising

first sample and hold circuit ($700_1$) with a hold capacitor arranged to provide a charge sample in every odd period of said FM signal and to hold the charge during the following even period of said FM signal,
second sample and hold circuit ($700_2$) with a hold capacitor arranged to provide a charge sample in every even period of said FM signal and to hold the charge during the following odd period of said FM signal,
means (S3,S4) for switching a charge sample to the converter from the first sample and hold circuit ($700_1$) during every even period and from the second sample and hold circuit ($700_2$) during every odd period of the FM signal in order to have a pipeline operation.

15. The demodulator according to claim 11, 12, 13 or 14, further comprising an integrating negative feedback circuit (55,57) from the analog voltage output of the converter (56) to the input of the converter for summing a feedback charge sample to charge sample in the hold capacitor, said integrating feedback circuit having an integration time constant which corresponds to a frequency which is substantially lower than the desired frequency band of said analog voltage signal.

16. The demodulator according to any one of claims 9-15, wherein said FM signal is an intermediate frequency FM signal converted down from a radio frequency FM signal by a mixer.

8

Fig. 1

Fig. 2

Fig. 3

Fig. 4A

Fig. 4B

Fig. 4C

Fig. 4D

**Fig. 5**

**Fig. 6A**

**Fig. 6B**

**Fig. 6C**

**Fig. 6D**

**Fig. 6E**

**Fig. 7**

Fig. 8A

$T_{IF}$

IF

Fig. 8B

$T_0$

$T_1$

$T_J$

P1

Fig. 8C

$T_2$

P2

Fig. 8D

$V_N$

$V(C_H)$

Fig. 9

$700_1$

91

$P_{21}$

IF

PWM PULSE
MODULATOR

$P_{11}$

CURRENT
SWITCH
CIRCUIT

$V_n(1)$   S3   $V_n$

$700_2$

$P_{22}$

$P_{12}$

CURRENT
SWITCH
CIRCUIT

$V_n(2)$

S4

SELECT